# EUROPEAN PATENT APPLICATION

(11) **EP 1 662 579 A1**
(43) Date of publication of application: **31.05.2006**
(21) Application number: 04257328.7
(22) Date of filing: 25.11.2004
(51) Int. Cl.: H01L 31/0248, H01L 31/0352, H01L 21/761

(54) **Photodiode detector**

(71) Applicant: STMicroelectronics (Research & Development) Limited, Marlow, Buckinghamshire SL7 1YL (GB)
(72) Inventor: Raynor, Jeffrey, Edinburgh EH12 5HZ (GB)
(74) Representative: Cooper, John

(57) **Abstract**

A photodiode comprising a substrate comprised of a first semiconductor material and an isolating layer of a second semiconductor material
wherein the second semiconductor material is of opposite doping character to the first semiconductor material, and
wherein the isolating layer of the second semiconductor material is implanted with one or more wells of the first and second semiconductor materials
characterised in that the substrate is separated from the isolating layer of the second semiconductor material by an epitaxial layer of the first semiconductor material.

## Description

The present invention relates to a photodiode detector and in particular a high-speed photodiode detector.

### Background of the invention

Recent, rapid developments in the field of optical communication systems and optoelectronics have led to an increased demand for high-speed photodetectors.
Photodiodes are pn junction semiconductor photodetectors that are already used in a wide variety of applications such as optical mice and cameras.

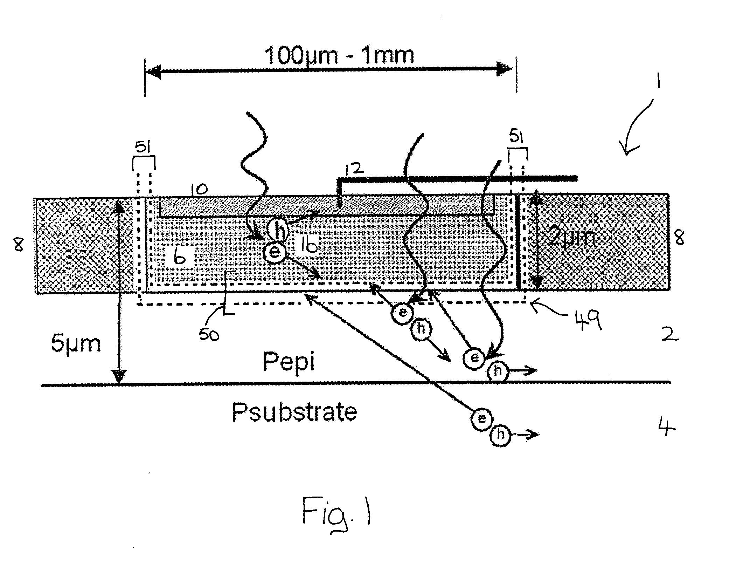

Figure 1 shows a cross-sectional view of a conventional photodiode 1. The photodiode 1 comprises a layer of P epitaxial material 2 implanted into a P substrate 4. The P epitaxial layer 2 is itself implanted with an N well 6 with P wells 8 on either side. For the sake of brevity, the P epitaxial layer 2 and P wells 8 will be collectively known henceforth as the P regions.

A highly doped N+ implant 10 and P+ implant (not shown) is embedded in the N well 6 and P wells respectively to provide electrical contact between the wells and the outside world. To complete the electrical contact, a first end of a contact 12 is embedded in the N+ implant 10 and the second end of the contact 12 is connected to external circuitry (not shown). Accordingly, the N wells 6, P wells 8 and associated N+ implants 10 and P+ implants form the top surface of the photodiode 1 onto which, in use, incident light falls.

For the sake of clarity, the term "vertical" as used in the rest of this Specification, will refer to the direction pointing from the P substrate 4 of a photodiode 1 to the top surface of the photodiode 1. The term "horizontal" as used in the rest of this Specification will refer to the direction substantially perpendicular to the "vertical" direction.

In use, the P substrate 4 and P epitaxial layer 2 are typically biased at 0V. In addition, the N well 6 is usually positively biased. These biasing conditions lead to the creation of a depletion region 49, with a vertical component 50 at the junction between the N well 6 and the P epitaxial layer 2 and a horizontal component 51 at the junctions between the N well 6 and the P wells 8.

The widths of the vertical and horizontal components 50, 51 of the depletion region 49 are dependent on the bias voltages applied to the N well 6, P wells 8 and the P epitaxial layer 2 as discussed above. The widths of the vertical and horizontal components 50, 51 of the depletion region 49 are also dependent on the concentration of the dopants in the N well 6 and the P regions. Since the P wells 8 are typically more heavily doped (e.g. 10⁻¹⁷) than the P epitaxial layer 2 (e.g. 10⁻¹⁵), the vertical component 50 of the depletion region 49 at the junction between the N well 6 and the P epitaxial layer 2 is typically larger than the horizontal component 51 of the depletion region 49 at the junctions between the N well 6 and the P wells 8.

The depletion region 49 determines the capacitance of the junctions between the N well 6 and the P region. The capacitance of these junctions is a determining factor for a number of the electrical characteristics of the photodiode 1 such as the full-well capacitance, photon shot noise, conversion gain and sensitivity. Furthermore, the time constant of the capacitance τ_{RC} is an important factor in determining the overall time constant of the photodiode 1.

When a photodiode 1 is illuminated, the incident light causes charge carriers (i.e. electron-hole pairs 16) to be generated in the bulk semiconductor material (2, 6 and 8). The photogenerated electrons and holes randomly move about in the semiconductor material by means of a thermally-controlled diffusion process until they either recombine or reach the depletion region 49. If the photogenerated charge carriers reach the depletion region 49, the electrical fields associated with the depletion region 49 draw the charge carriers across the corresponding semiconductor junctions and thereby produce a photocurrent that is transmitted to the external circuitry.

Since the movement of photogenerated charge carriers 16 through a semiconductor material is inherently random in nature, a charge carrier generated deep within the bulk of a semiconductor material may take a considerable amount of time to reach the vertical or horizontal components 50, 51 of the depletion region 49. The delay between the photo-generation of charge carriers and the arrival of the charge carriers at the depletion region 49 is another major factor in determining the response time of the photodiode 1. This delay is also known as the transit time τₜᵣ and in a conventional photodiode is approximately 5-50ns in duration.

In practice, the transit time τₜᵣ is dependent upon the distance between the photo-generation of a charge carrier and the nearest depletion region thereto (which is in turn dependent upon the width of the depletion region), temperature, doping levels and the saturation velocity of the semiconductor material 2, 6 and 8. The delay caused by the transit time τₜᵣ is insignificant for most of the conventional applications of photodiodes. For instance, even high-speed mice detectors operate at 10kHz, thus allowing photo-generated carriers 100ms to reach a depletion region.

Optical communications systems frequently employ red light (λ = 600nm-650nm) as a transmission medium since many photo-emitters (e.g. light emitting diodes (LEDs) and vertical cavity surface emitting lasers (VCSELs)) operate particularly efficiently at this wavelength. When red light is incident upon a photodiode 1, the majority of the resulting charge carriers are generated deep (> 2µm) within the bulk silicon (e.g. P substrate 4 and P epitaxial layer 2). Consequently, the majority of the photo-generated charge carriers can remain in the semiconductor material for a considerable period of time before reaching the depletion region 49.

The signals transmitted in an optical communications system are typically pulsatile in nature with each pulse representing a particular data symbol. The bandwidth of a photodiode 1 in an optical communications system is defined as the maximum frequency or bit-rate at which the photodiode 1 can detect light pulses without making errors. Given the high-speed of data transmission in an optical communications system, the time constant of the photodetector is clearly a significant concern. In particular, since the transit time τₜᵣ of a photodiode 1 with red-light illumination can be quite significant compared with the frequency of the transmitted light signal, photo-generated charge carriers which arrive late at the depletion region 49 can cause the received edges of a signal pulse to be "blurred out", leading to inter-symbol interference.

A number of attempts have been made in the past to overcome this problem including the use of III-V photodetectors (US2003/0215971). III-V devices employ compound semiconductors such as GaAs, GaN, InP, InSb whose band-gaps can be engineered to produce structures with high electrical fields and thus high operating speeds (> 1Gbits/sec). However, this technology is considerably less mature and thus more expensive than silicon processing.

Another method of reducing the transit time τₜᵣ of a photodiode involves the use of PIN structures. A PIN structure uses a thick layer of undoped (intrinsic) material sandwiched between the P and N type layers. Since no free charge carriers are produced in the intrinsic layer, the space-charge region (i.e. the depletion region) is increased, thereby effectively increasing the active region of the photodiode. Furthermore, a large electrical field is generated across the intrinsic material that accelerates the movement of photoelectrons to the depletion region and thereby reduces the transit time of the structure. Whilst PIN structures are already used in high-speed detectors, a specialized manufacturing process is required to generate the PIN structures, which involves extensive adaptation of existing silicon processing technology. Such requirements thereby increase the cost of PIN devices.

Another method of overcoming the problem of inter-symbol interference relies upon the use of digital signal processing techniques rather than a manipulation of the semiconductor structure of the photodiode. In particular, depending on the modulation technique employed in the optical communications system, it is possible to use time-domain filtering to improve the inter-symbol response of the communications system (e.g. US2002/0167703). However, in addition to adding to the cost of the optical communications system, this technique does not address the source of the inter-symbol interference, namely the photodiode itself.

The process of vertically stacking diodes in silicon is well-known and is used for spectrally sensitive detectors (e.g. US 5965875). These devices detect colour by determining the depth at which photo-electrons are generated by incident photons. However, these colour sensors typically operate in an integrating mode and thereby operate at considerably lower speeds than those required for optical communication systems.

### Summary of the Invention

The present invention is directed to a photodiode, photodiode detector, optical mouse and digital camera as defined in the independent claims. Further embodiments of the invention are provided in the dependent claims.

### Advantages of the Invention

The present invention enables the construction of high-speed photodiodes using standard PMOS, NMOS or CMOS processing technologies and thus contrasts with the specialized procedures required for manufacturing III-V sensors and including the intrinsic layer into a PIN photodetector.

Furthermore, the present invention enables the inclusion of a high-speed photodiode onto the same silicon chip as advanced digital electronics (e.g. filter, encoder, encryption, decryption, decoding, network protocol implementation), thereby providing the possibility of creating a complete optical communications system on a single chip.

### Description and Drawings

Five embodiments of the invention will now be described by way of example only with reference to the accompanying drawings in which:
Figure 2 is a cross sectional view of the photodiode in the first embodiment of the photodiode detector wherein the photodiode includes two vertical depletion regions;
Figure 3a is a cross-sectional view of an example of a twin well structure;
Figure 3b is a cross-sectional view of an example of a triple-well structure;
Figure 4 is a cross-sectional view of the photodiode in the first embodiment of the photodiode detector shown in Figure 2, showing the movement of photogenerated charge carriers through the photodiode;
Figure 5 is a circuit diagram representation of the first embodiment of the photodiode detector, the photodiode component being shown in Figures 2 and 4;
Figure 6 is a cross-sectional view of the photodiode in the second embodiment of the photodiode detector wherein the photodiode includes three vertical depletion regions;
Figure 7 is a cross-sectional view of the photodiode in the second embodiment of the photodiode detector shown in Figure 6, showing the movement of photogenerated charge carriers through the photodiode;
Figure 8 is a circuit diagram representation of the second embodiment of the photodiode detector, the photodiode component being shown in Figures 6 and 7;
Figure 9 is a cross-sectional view of the photodiode in the third embodiment of the photodiode detector shown in Figures 6 and 7, wherein the photodiode includes multiple P+ and N+ implants and three vertical depletion regions;
Figure 10 is a cross-sectional view of the photodiode in the fourth embodiment of the photodiode detector, wherein the photodiode includes two vertical depletion regions and one horizontal depletion region;
Figure 11 is a top plan view of the fourth embodiment of the photodiode detector shown in Figure 10;
Figure 12 is cross-sectional view of the photodiode in the fourth embodiment of the photodiode detector shown in Figure 10, showing the movement of photo-generated charge carriers through the photodiode;
Figure 13a is a circuit diagram representation of the fourth embodiment of the photodiode detector, the photodiode component being shown in Figures 10, 11 and 12;
Figure 13b is a circuit diagram representation of the fourth embodiment of the photodiode detector, the photodiode component being shown in Figures 10, 11 and 12; wherein the transimpedance amplifier is employed with a cascode transistor structure;
Figure 13c is a circuit diagram representation of the fourth embodiment of the photodiode detector, the photodiode component being shown in Figures 10, 11 and 12; wherein the transimpedance amplifier is employed with a regulated cascode transistor structure;
Figure 14 is a cross-sectional view of the photodiode in the fifth embodiment of the photodiode detector, wherein the photodiode includes three vertical depletion regions and one horizontal depletion region;
Figure 15a is a circuit diagram representation of the fifth embodiment of the photodiode detector, the photodiode component being shown in Figure 14;
Figure 15b is a circuit diagram representation of the fifth embodiment of the photodiode detector, the photodiode component being shown in Figure 14, wherein the photodiode detector is employed with a cascode transistor structure; and
Figure 16 is a cross-sectional view of a N-type substrate implementation of the first embodiment of the photodiode detector.

The present invention uses a novel structure to reduce the distance traveled by photogenerated charge carriers within the bulk semiconductor material before reaching a depletion layer and being detected. In particular, the present invention uses a novel semiconductor structure producing vertical and horizontal depletion regions to limit the vertical and horizontal diffusion of charge carriers before being detected.

Following the logical development of the structures employed in the present invention, the following discussion will first describe the structures used for preventing vertical diffusion and will then turn to the structures used for preventing horizontal and vertical diffusion of photogenerated charge carriers.

For the sake of brevity, each embodiment of the photodiode detector will be referred to by its number. In other words, the first embodiment of the photodiode detector will be referred to as the first photodiode detector, the second embodiment of the photodiode detector will be referred to as the second photodiode detector, and so forth.

### A. Vertical Inhibition of the Movement of Photo-generated Charge Carriers

### (1) First Photodiode Detector Employing Two Vertical Depletion Regions

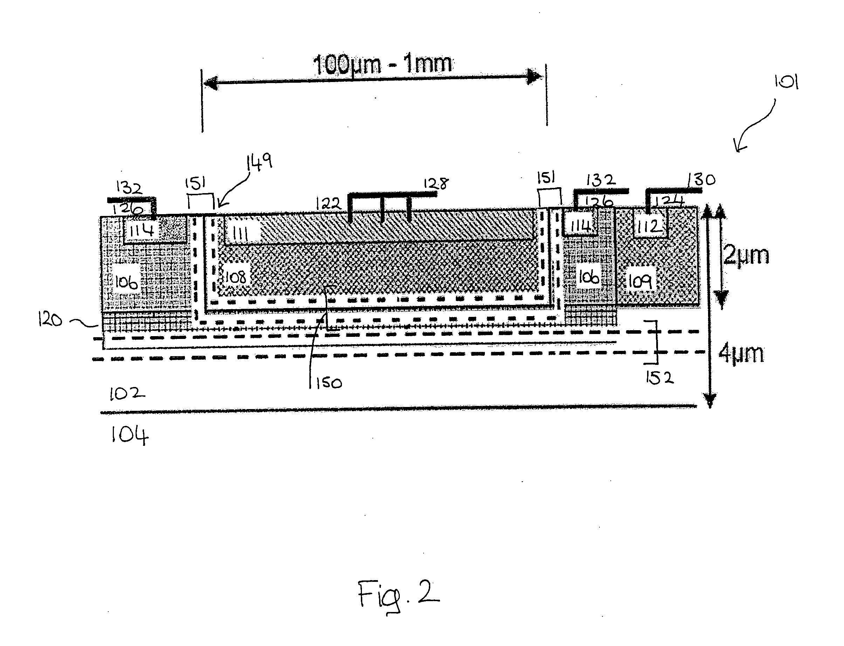

Referring to Figure 2, in common with the conventional photodiode (shown in Figure 1) the photodiode 101 in the first photodiode detector comprises a P substrate 104 implanted with a P epitaxial layer 102. In contrast with the conventional photodiode, a NISO layer 120 is implanted into a portion of the P epitaxial layer 102 and a P well 108 and an N well 106 are implanted into the NISO layer 120. A further P well 109 is implanted into the P epitaxial layer 102 in a position adjoining one of the N wells 106.

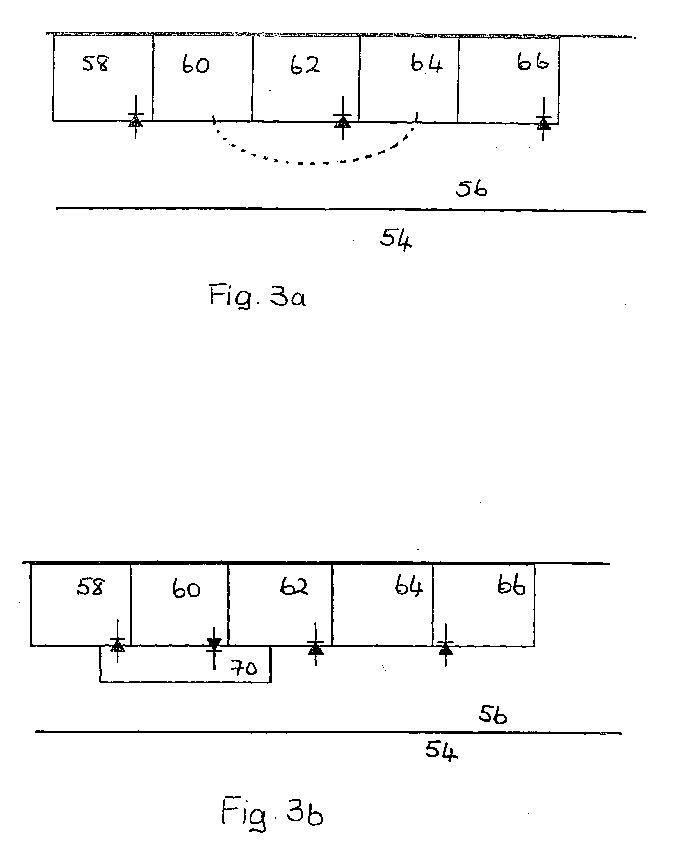

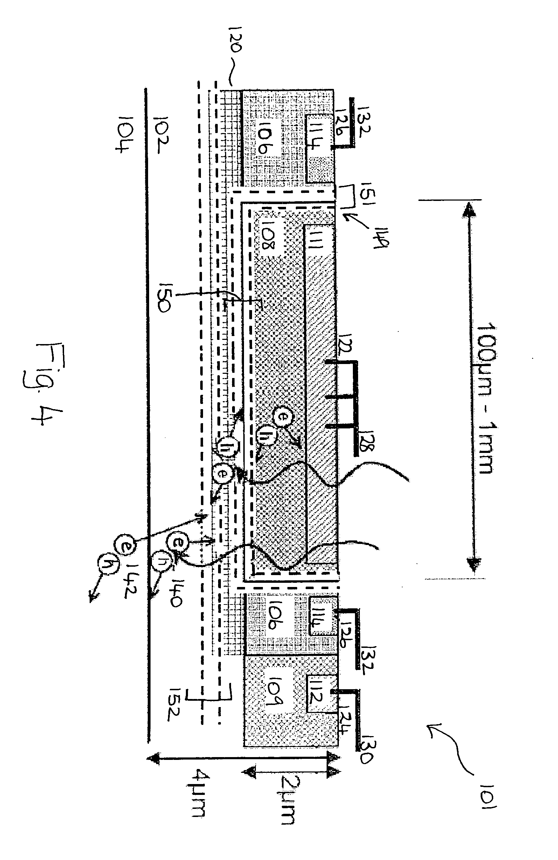

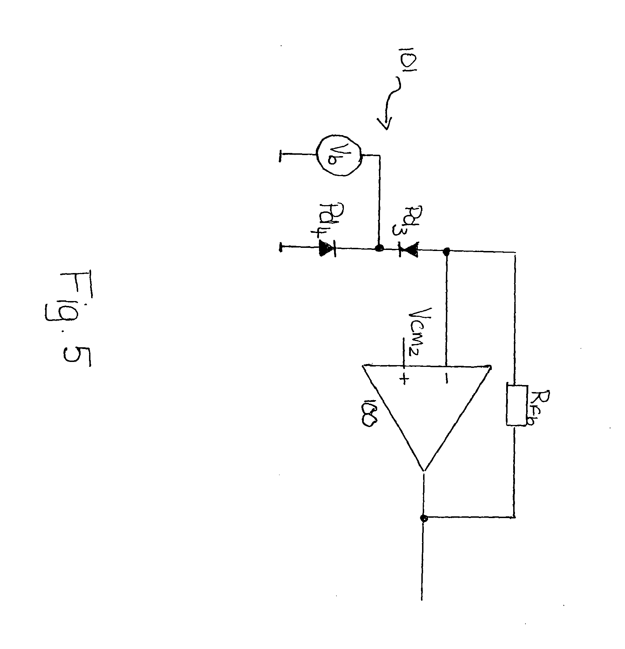

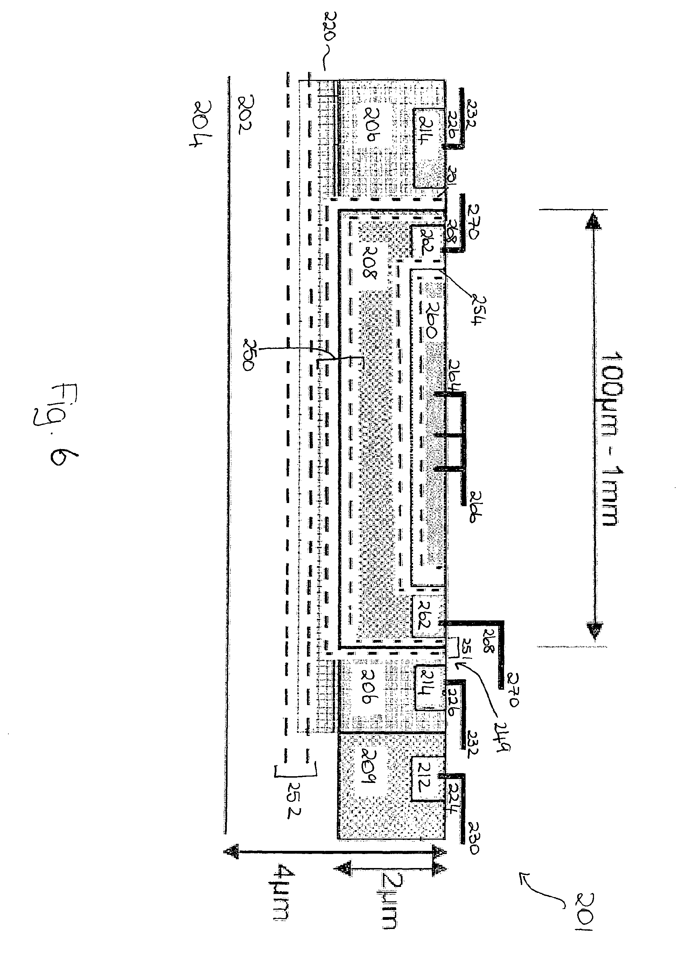

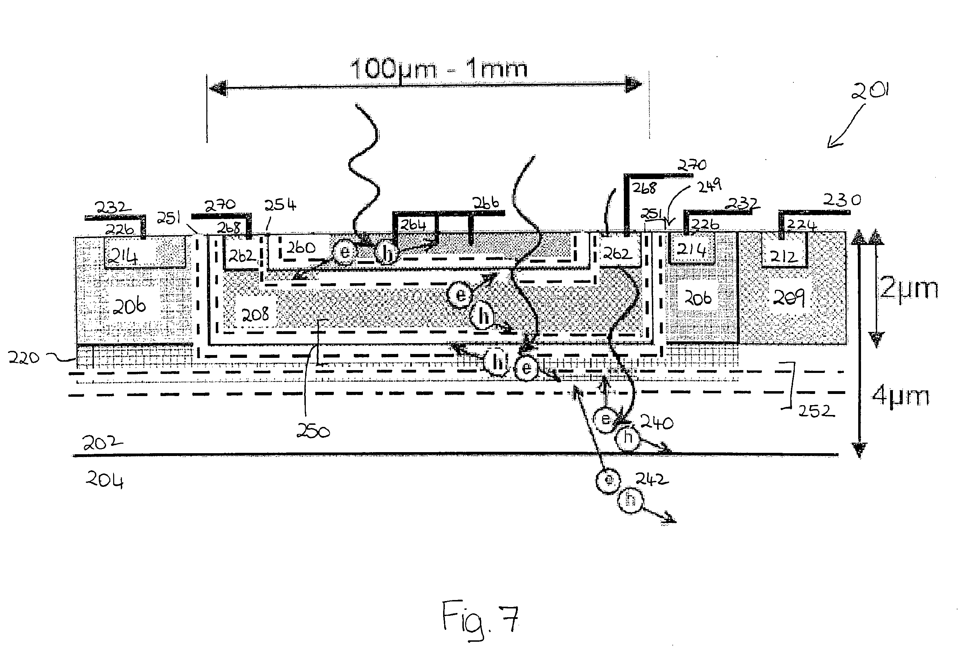

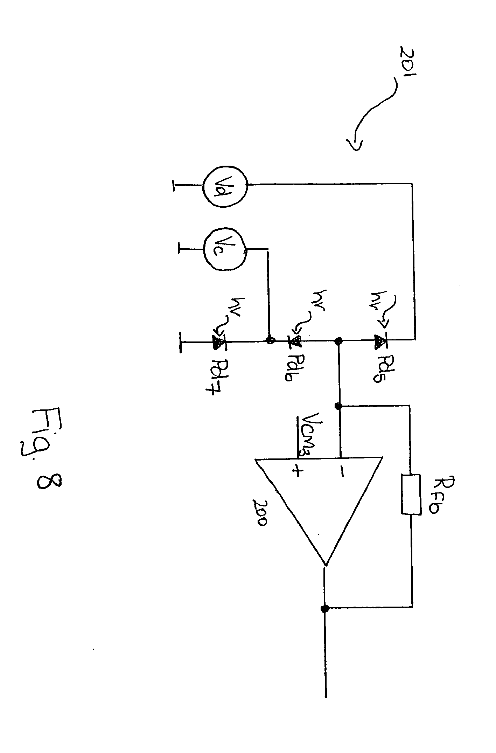

The NISO layer 120, P well 108 and N wells 106 effectively form a triple well structure in the P epitaxial layer 102. The function of this triple well structure is explained with reference to Figure 3a and 3b. Figure 3a shows a traditional double well structure wherein a P substrate 54 is implanted with a P epitaxial layer 56 and the P epitaxial layer 56 is itself implanted with substantially alternating P wells 60 and 64 and N wells 58, 62 and 66.

For an NMOS or PMOS transistor to operate, the transistor must employ a well of the opposite semiconductor type. In other words, a NMOS transistor must employ a P well and a PMOS transistor must employ an N well. This ensures that a reverse biased diode is effectively located between the transistor's source and drain and the bulk semiconductor material. Accordingly, this ensures that there is no current flow through the bulk semiconductor material from the transistor's source and drain. For analogue circuits, it is often desirable to bias the wells at a specific level (e.g. to reduce the body effect in a source-follower configuration). This is particularly difficult for the P wells 60, 64 in the two-well structure, as the P wells 60, 64 are effectively connected through the P epitaxial layer 56. However, it does not pose any problems for the N wells 58, 62 and 66 as there is a reverse biased diode formed between the N wells 58, 62 and 66 and the P substrate 54 that prevents current flow.

This problem can be overcome using the triple well structure shown in Figure 3b, in this case a secondary N well 70 is implanted into a portion of the P epitaxial layer 56 centred around a P well 60. The secondary N well 70 is implanted deeper than the P well 60 and thus forms a PN junction with the P well 60. Accordingly, the secondary N well 70 forms a reverse biased diode between the P well 60 and the P epitaxial layer 56 and the P substrate 54. In effect, the secondary N well 70 isolates alternating P wells 60, 64 and is thus known as a NISO layer 70. It is usually necessary to overlap the P wells 60, 64 with the NISO layer 70. However, this causes a short between alternating N wells 58, 62. If the N well 58, 62 short causes a problem, it can be overcome by using a separate N well 66 isolated by P well 64.

Returning to the first photodiode detector shown in Figure 2, electrical contact between the P wells 108 and 109 and the outside world is provided by highly doped P+ implants 111 and 112 in the P wells 108 and 109 respectively. The electrical contact is completed by contacts 122 and 124 embedded at one end in the P+ implants 111 and 112 respectively and connected at their other end to conductors 128 and 130 respectively.

Electrical contact between the N wells 106 and the outside world is provided by a highly doped N+ implant 114 in each N well 106. The electrical contact is completed by contacts 126 embedded at one end in each of the N+ implants 114 and connected at the other end to conductors 132. The conductors 128, 130 and 132 may be fabricated from a metal, a polysilicon (with field oxide underneath to prevent the formation of parasitic transistors) or other local-interconnect.

Comparing Figure 1 with Figure 2, it can be seen that in contrast with the single depletion region 49 formed between the N well 6 and P material (2 and 8) of the conventional photodiode, the photodiode 101 in the first photodiode detector includes two depletion regions 149 and 152. The first depletion region 149 comprises a horizontal component 151 and a vertical component 150. The vertical component 150 is located at the junction between the P well 108 and the NISO layer 120. The horizontal component 151 is located at the junction between the N well 106 and the P well 108.

The second depletion region 152 is located at the junction between the NISO layer 120 and the P epitaxial layer 102. In effect, the two depletion regions 149 and 152 act as two diodes in the vertical direction in which the first depletion region 149 collects photo-generated charge carriers from the surface of the photodiode 101 and the second depletion region 152 collects the photo-generated charge carriers produced in the bulk semiconductor material.

In use, the signal produced by the photodiode 101 in the first photodiode detector is obtained by measuring the photo- generated charge carriers collected at the first depletion region 149. The resulting photocurrent is output to external circuitry via the P+ implant 111, through contact 122 and conductor 128. The photocurrent in the P+ implant 111 is comprised of minority charge carriers (i.e. holes). Since holes are typically less mobile than electrons, it is necessary to employ multiple contacts 122 distributed over the surface of the P+ region 111 (with a typical spacing 2µm-5µm) to collect the holes.

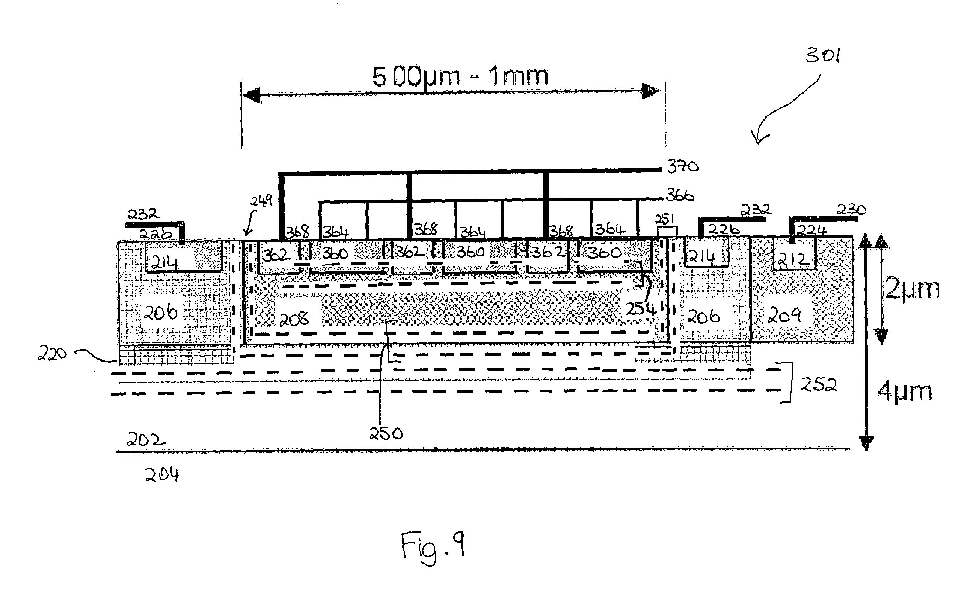

The advantage of the photodiode 101 in the first photodiode detector over conventional photodiodes is best understood when the photo-generated charge carriers are shown as depicted in Figure 4. Of the charge carriers (electron-hole pairs) 140 generated deep within the semiconductor (in the P epitaxial layer 102 and the P substrate 104), the electrons diffuse to the depletion region 152 formed at the junction between the NISO layer 120 and the P epitaxial layer 102 and are removed from the bulk semiconductor by flowing through the N wells 106, N+ implants 114 and contacts 126. The photogenerated holes 140, 142 are removed from the bulk semiconductor by flowing through the P well 109 and the P+ implant 112 before flowing through the distributed contacts 124 and the conductor 130. Accordingly, the P well 109, P+ implant 112 and its contacts 124 effectively provide a ground contact to the P substrate 104.

Charge carriers generated at shallower depths in the semiconductor material (i.e. in the NISO layer 120 and P well 108) are collected by the vertical component 150 of the depletion region 149 (formed at the junction between the P well 108 and the NISO layer 120). The photocurrent generated at the vertical component 150 of the depletion region 149 corresponds with the overall photocurrent measured from the photodiode 101 and flows through the P+ implant 111 by diffusion to the contacts 122 and the conductor 128.

The photodiode 101 in the first photodiode detector is best realized in a "triple well" process as it provides the deeper NISO structure. This depth is very suitable for the red light wavelengths used in many optical communications systems. It should be noted that whilst bipolar-CMOS processes do not normally provide a triple well structure, these processes involve a deep, N implantation step that could provide similar function to the deep NISO structure.

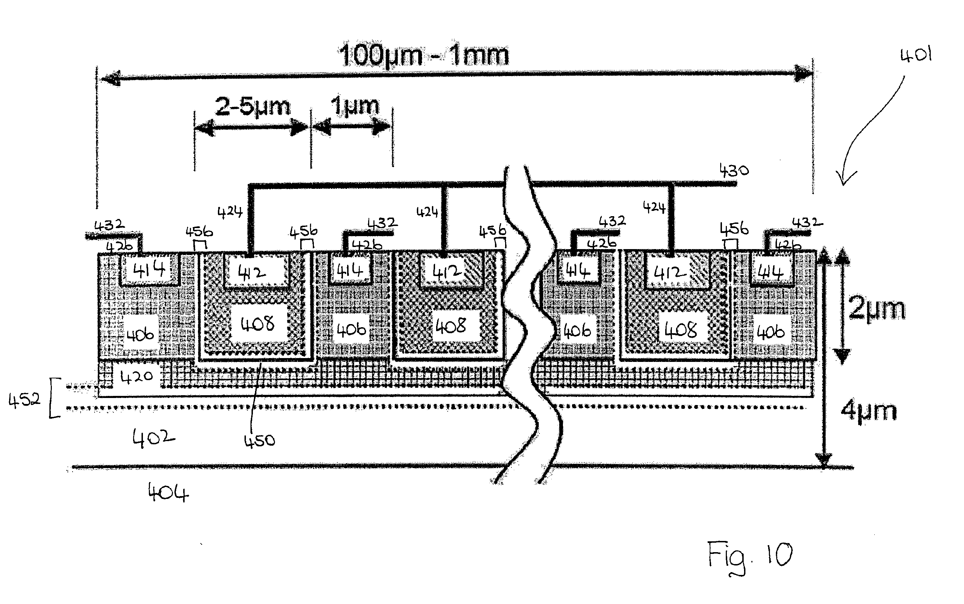

Figure 5 shows a circuit diagram representation of the first improved photodiode 101. Photodiode Pd₃ is equivalent to the horizontal and vertical components 150, 151 of the first depletion region 149 (in Figures 2 and 4). Photodiode Pd₄ is equivalent to the second depletion region 152 (in Figures 2 and 4). Voltage Vb is set positive to ensure that diode Pd₄ is maintained in a reverse biased condition and hence capable of collecting photo-generated charge carriers.

Referring to Figures 4 and 5, as mentioned earlier, the photocurrent generated at the horizontal and vertical components 150, 151 of the first depletion region 149 corresponds with the overall photocurrent measured from the photodiode 101 in the first photodiode detector. Continuing the circuit diagram analogy, the photodiode Pd₃ is thus used to detect the overall output signal from the photodiode 101.

A depletion region possesses an electric field that specifically directs and accelerates the movement of photogenerated charge carriers therein. In contrast, the semiconductor material located outside of a depletion layer does not possess any such field and the photogenerated charge carriers located outside of the depletion region are moved by diffusion. Consequently the movement of photogenerated charge carriers located in the depletion region is considerably faster than those located outside of the depletion region. Thus, by increasing the size of a depletion region, the movement of charge carriers can be accelerated. Consequently, for optimal performance photodiode Pd₃ should correspond with the largest possible depletion region.

The size of a depletion region is determined by its doping profile and the voltage applied thereto. In the photodiode 101 in the first photodiode detector, increasing the voltage across the diode Pd₃ increases the width of the vertical component 150 of the depletion region 149. Accordingly, the optimal operating conditions of the first photodiode detector ensure that the voltage Vb is maintained as positive as possible and the voltage Vcm₂ is maintained as close to ground as possible.

The photodiode 101 in the first photodiode detector (as permitted by the operation of the amplifier 100) effectively employs two depletion regions (diodes) to inhibit the vertical movement of charge carriers located deep within the bulk semiconductor material. Although the majority of photo- generated charge carriers are typically produced deep within the bulk semiconductor material, nonetheless a considerable number of charge carriers are generated nearer the surface of the photodiode 101. Since the region near the surface of the photodiode 101 is located outside of the depletion regions 149 and 152, the charge carriers generated near the surface of the photodiode 101 will be forced to rely on diffusion to reach the depletion region 149 and will thus take a considerable amount of time to be detected. Consequently, charge carriers produced near the surface of the photodiode 101 in the first photodiode detector can degrade the response time of the first photodiode detector and thereby contribute to inter-symbol interference.

The photodiode in the second photodiode detector employs three depletion regions in which the top-most depletion region absorbs the photo-generated charge carriers produced near the surface of the photodiode and thus prevents these photo-generated charge carriers from degrading the signal from the photodiode.

Referring to Figure 6, in common with the photodiode in the first photodiode detector, the photodiode 201 in the second photodiode detector comprises a P substrate 204 implanted with a P epitaxial layer 202. A portion of the P epitaxial layer 202 is implanted with a NISO layer 220. The NISO layer 220 is in turn implanted with a P well 208 surrounded on both sides by N wells 206. A further P well 209 is implanted in the P epitaxial layer 202 in a position adjoining one of the N wells 206.

In contrast with the photodiode in the first photodiode detector, electrical contact between the P well 208 and the outside world is provided by a highly doped N+ implant 260 with a highly doped P+ implant 262 on either side. It should be noted that it may be preferable (but not necessary) to employ multiple P+ implants 262. Electrical contact with the N+ implant 260 is completed by multiple contacts 264 embedded at one end in the N+ implant 260 and connected at the other end to conductor 266. Electrical contact with the P+ implants 262 is completed by contacts 268 each of which is embedded at one end in one of the P+ regions 262 and connected at their other end to conductors 270.

Electrical contact with the N wells 206 is provided by highly doped N+ implants 214. Electrical contact with the N wells 206 is completed by contacts 226 embedded at one end in the N+ implants 214 and connected at the other end to conductors 232. Finally, electrical contact with the P well 209 is provided by a highly doped P+ implant 212 and completed by a contact 224 embedded at one end in the P+ implant 212 and connected at the other end to a conductor 230.

Comparing Figure 6 with Figure 2 it can be seen that in contrast with the two depletion regions 149 and 151 formed in the photodiode 101 in the first photodiode detector, the photodiode 201 in the second photodiode detector includes three depletion regions 249, 252 and 254. In particular, the first depletion region 249 comprises a vertical component 250 and a horizontal component 251. The vertical component 250 of the first depletion region 249 is located at the junction between the P well 208 and the NISO layer 220. The horizontal component 251 of the first depletion region 249 is located at the junction between the P well 208 and the N well 206.

The second depletion region 252 is located at the junction between the NISO layer 220 and the P epitaxial layer 202. The third depletion region 254 is formed at the junction between the N+ implant 260 and the P well 208.

In a similar fashion to the photodiode 101 in the first photodiode detector, the overall photocurrent produced by the photodiode 201 in the second photodiode detector comprises the photo-generated charge carriers collected at the horizontal and vertical components 250, 251 of the first depletion region 249. The overall photocurrent from the horizontal and vertical components 250, 251 of the first depletion region 249 is output to external circuitry via the P+ implants 262 through contacts 268 and conductors 270.

The advantage of the photodiode 201 in the second photodiode detector, over conventional photodiodes is best understood when photo-generated charge is shown as depicted in Figure 7. As in the photodiode in the first photodiode detector, charge carriers 240 and 242 generated deep in the silicon (i.e. in the P substrate 204 and P epitaxial layer 202) diffuse to the depletion region 252 formed at the junction between the NISO layer 220 and the P epitaxial layer 202. Charge carriers generated near the top surface of the photodiode 201 (i.e. in the N+ implant 260) diffuse to the depletion region 254 formed at the junction between the N+ implant 260 and the P well 208. These photogenerated charge carriers can be removed from the photodiode 201 via contacts 264 distributed over the surface of the N+ implant 260.

Referring to Figures 6, 7 and 8 the depletion region 254 formed at the junction between the N+ implant 260 and the P well 208 can be represented by the photodiode Pd₅. Similarly, the vertical component 250 of the depletion region 249 formed at the junction between the P well 208 and the NISO layer 220 can be represented by the photodiode Pd₆ and the depletion region 252 formed at the junction between the NISO layer 220 and the P epitaxial layer 202 can be represented by the photodiode Pd₇.

Bias voltages Vc and Vd are set positive to ensure that diodes Pd₅ and Pd₇ are maintained in a reverse biased state and thus capable of collecting photo-generated charge carriers. Voltage Vcm₃ is also set as close to ground as possible.

Feedback around the transimpedance amplifier 200 ensures that the voltage Vcm₃ is maintained on the photodiode Pd₆. Consequently, photodiode Pd₆ remains reverse-biased, thereby creating the vertical component 250 of the depletion region 249. Since the overall photocurrent produced by the photodiode 201 comprises the photogenerated charge carriers collected at the vertical component 250 of the depletion region 249, using the circuit diagram analogy the photodiode Pd₆ is thus used to detect the overall output signal from the photodiode 201 in the second photodiode detector circuit.

To achieve optimal performance from the photodiode 201 in the second photodiode detector, the vertical component 250 of the depletion region 249 should be as large as possible. Increasing the voltage across the photodiode Pd₆ increases the vertical component 250 of the depletion region 249. Consequently, the optimal operating conditions for the second photodiode detector are achieved when the voltage Vc is maintained as positive as possible and the voltage Vcm₃ is maintained as close to ground as possible.

However, the process of setting the voltage Vd is a more complex affair. Whilst Vd could be set to the same voltage as Vc, it would cause the depletion region 254 (corresponding with photodiode Pd₅) to grow at the expense of the vertical component 250 of the depletion region 249 (corresponding with detection diode Pd₆). This has a negative effect on the second photodiode detector's sensitivity to incident light. Consequently, the optimum setting for Vd is that which causes depletion region 254 to grow until it touches depletion region 250. The operating conditions suitable for achieving this effect can be determined theoretically if the doping profile of the process is known. Otherwise, the required operating conditions can be determined experimentally.

Whilst there are some similarities between the semiconductor structure of the photodiode 201 in the second photodiode detector and the stacked diode structure described in US5965875 the latter structure was designed as a colour- detecting sensor for use in an imaging apparatus. It will be understood that imaging applications do not generally require the fast response times demanded by high speed optical communications systems.

The difference between the objectives of the stacked diode structure of US5965875 and the second photodiode detector is further reflected in the operational modes of the two structures. In particular, it will be recalled that the stacked diode structure of US5965875 operates in an integration mode wherein photogenerated charge carriers are collected in a capacitor (i.e. either a capacitor integrated within the photodiode or provided as part of the external circuitry) and the output signal therefrom is thus a voltage signal. In contrast, the second photodiode detector directly outputs the photocurrent from photogenerated charge carriers and thus has a much faster response time than the stacked diode structure of US5965875. The signal readout process of the second photodiode detector is facilitated by the transimpedance amplifier 200, which is not present in the stacked diode structure of US5965875.

As an aside, and referring to Figure 9, it will be recalled that the photocurrent generated in the P well 208 is comprised of minority charge carriers (i.e. holes) that are typically less mobile than electrons. Whilst the photodiode 201 in the second photodiode detector depicted in Figures 6 and 7 possessed two P+ implants 262, it is preferable to employ multiple P+ implants 362 and N+ implants 360 to collect photogenerated holes and thereby reduce any performance degradation of the second photodiode detector.

In this case, electrical contact with each N+ implant 360 is provided with two contacts 364 embedded at one end in the N+ implant 360 and connected at the other end to a contact 366. Electrical contact with each P+ implant 362 is provided with a contact 368 embedded at one end in the P+ implant 362 and connected at the other end to a conductor 370.

### B. Horizontal Inhibition of Charge Carrier Movement

The discussion so far has focused on the inhibition of vertical diffusion of photogenerated charge carriers. The previously described inhibition structures prevent charge carriers that have been photo-generated deep within the semiconductor from reaching a receiving node (i.e. N+/P+ implants and connectors). However, it is not always possible to increase the depletion region across the full width of the photodiode.

Referring to Figure 10, the photodiode 401 in the fourth photodiode detector comprises a P substrate 404 implanted with a P epitaxial layer 402. A portion of the P epitaxial layer 402 is coated with a NISO layer 420. The NISO layer 420 is implanted with a series of alternating P wells 408 and N well guard rings 406.

Electrical contact between the N well guard rings 406 and the outside world is provided by a highly doped N+ implant 414 in each N well 406. The electrical contact with each N well guard ring 406 is completed by a contact 426 embedded at one end in the N+ implant 414 and connected at the other end to wiring 432. The wiring 432 connects all the N+ type implants 414 in parallel.

Electrical contact between each light-collecting P well 408 and the outside world is provided by a highly doped P+ implant 412. The electrical contact is completed by a contact 424 embedded at one end in each P+ implant 412 and connected at the other end to wiring 430. The wiring 430 connects all the P+ implants 412 in parallel and outputs the photo-generated current to readout amplifiers.

In contrast with the single depletion region of conventional photodiodes, the photodiode 401 in the fourth photodiode detector comprises three depletion regions 450, 452 and 456, two of which (450 and 452) are vertical and the remaining depletion region is horizontal.

The first depletion region 450 is formed at the junction between the P well 408 and the NISO layer 420, and serves to collect vertically diffusing charge carriers.

The second vertical depletion region 452 is formed at the junction between the NISO layer 420 and the P epitaxial layer 402 and serves to inhibit vertical diffusion of charge carriers. Finally, the horizontal depletion region 456 is formed at the junction between the P well 408 and N well 406 junction and serves to collect charge and inhibit lateral diffusion of charge carriers.

Since the N well 406 structures are present to inhibit lateral diffusion they should be made as small as possible.

However, this feature is limited by process technology design rules. The edge of the entire fourth photodiode structure should be an N well structure 406 to collect carriers generated outside the main area of the photodiode 401.

The size of the P well 408 structures represents a compromise between the conflicting requirements of improved device sensitivity and increased response speed. In particular, whilst large P well structures 408 improve the collection efficiency and hence device sensitivity of a photodiode, the enhanced sensitivity is achieved at the cost of increased lateral diffusion and inter-symbol interference. Similarly, whilst smaller P well structures 408 reduce the lateral diffusion of photogenerated charge carriers, the small P well structures 408 decrease the size of the collection area and hence reduce the overall sensitivity of the photodiode. Furthermore, smaller P well structures 408 also increase the area of the sidewall and its capacitance.

The effect of the depletion region 450 is particularly important for the performance of the fourth photodiode detector. If the size of the depletion region 450 is increased, the volume of semiconductor available for the photocharge to diffuse is decreased accordingly. Consequently, the size of the P well area 408 can be increased without concern of increased inter-symbol interference. The size of the depletion region 450 is dependent on its semiconductor doping profile and the voltage applied thereto. At present, the depletion layer 450 is typically 2-5µm in width.

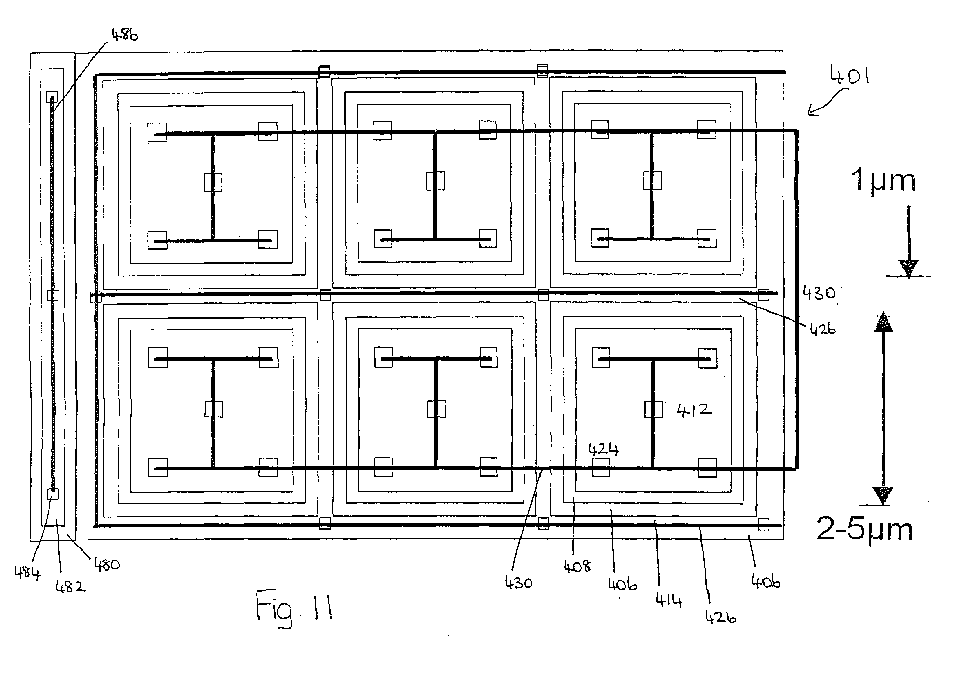

Referring to Figure 11, there are multiple contacts 424 at the collection region formed at the junction between the P well 408 and P+ implant 412. The number of contacts provided in each collection region represents a practical compromise that attempts to ensure a low resistance connection without significantly degrading the optical sensitivity of the high-speed photodetector.

Whilst no contact to the substrate P epitaxial layer 402 or the P substrate 404 is shown in Figure 10, it should be noted that the P substrate 404 must be connected to a voltage (i.e. ground) to create the second vertical depletion region 452 and draw away unwanted photo-generated charge carriers from the junction between the P epitaxial layer 402 and the bulk semiconductor (i.e. NISO layer 420, N well guard rings 406 and P wells 408) that would otherwise contribute to the inter-symbol interference of the fourth photodiode detector. These contacts are shown in Figure 11 and comprise a connection between a P well structure 480 and the P epitaxial layer (not shown). Electrical contact with the P well structure 480 is provided by a highly doped P+ implant 482 embedded therein and completed by a contact 484 embedded at one end in the P+ implant and connected at the other end to a conductor 486.

Referring to Figures 10 and 11, whilst the bulk contact structures 484 must be present in the photodiode 401 in the fourth improved photodiode detector, they do not need to be provided as frequently as the collection depletion regions 450 or the lateral inhibition depletion regions 456. Typically, the bulk contact structures 484 appear every 30µm-50µm inside the fourth photodiode detector structure. For optimal performance, the bulk contact structures 484 should also be disposed around the edge of the fourth photodiode detector structure as shown in Figure 11.

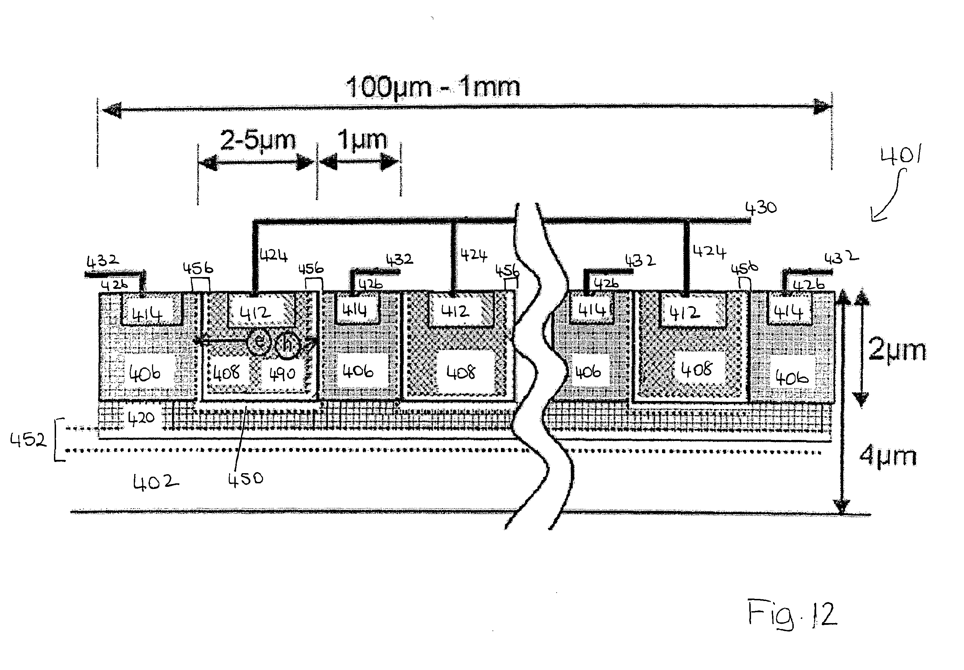

The advantage of the photodiode 401 in the fourth photodiode detector over the photodiodes in the previous photodiode detectors is best understood when photo-generated charge carriers are shown as depicted in Figure 12.

As an example, compare the electron-hole pair 490 shown in the P well 408 with the corresponding electron-hole pair in the photodiode 101 in the first photodiode detector (shown in Figure 4). In the photodiode 101 in the first photodiode detector, the charge carriers are able to diffuse **horizontally** through the P well 108 for a considerable distance before reaching the depletion region 149. However, in the photodiode 401 in the fourth photodiode detector, photogenerated charge carriers quickly reach the depletion region 456 formed at the junction between a P well 408 and a N well 406. Consequently, the photogenerated charge carriers in the photodiode 401 in the fourth photodiode detector are collected more quickly than those in the previous photodiode detectors. This decrease in collection time is greatly advantageous in reducing the group-delay and inter-symbol interference of the fourth photodiode detector.

The photocurrent of the photodiode 401 in the fourth photodiode detector flows through the P+ implant 412, the contacts 424 and conductor 430. Of the charge carriers generated deep within the bulk semiconductor material, the electrons diffuse **vertically** to the second vertical depletion region 452 whilst the holes flow through the bulk of the semiconductor. The photo-generated electrons may be removed from the photodiode 401 by flowing through the N wells 406 and N+ implants 414. The photogenerated holes 490 flow through the P wells 408 and the P+ implants 412 before flowing through the distributed bulk contacts (not shown) and associated conductor (not shown).

Comparing Figures 10, 12 and 13a, it can be seen that photodiodes Pd₃ and Pd₄ are equivalent to first and second vertical depletion regions 450 and 452 respectively. Similarly, photodiode Pd₅ is equivalent to the horizontal depletion region 456. Photodiode Pd₅ is configured in parallel to Pd₃ and in use its photocurrent is added to the photocurrent from Pd₃. Voltage Vb is set positive to ensure that diode Pd₄ is maintained in a reverse biased state and thus capable of collecting photo-generated charge.

From the perspective of the charge-collecting function of the fourth photodiode detector, diodes Pd₃ and Pd₅ are of greatest importance, as these diodes are effectively used to produce the overall output signal from the fourth photodiode detector. Accordingly, the depletion regions corresponding with these diodes (450 and 456) should have the largest area possible to increase the operating speed of the fourth photodiode detector.

Since the size of a depletion region is determined by its doping profile and the voltage applied thereto, the size of depletion regions 450 and 456 is increased by increasing the voltage across the diodes Pd₃ and Pd₅. Accordingly, the optimal operating conditions for the fourth photodiode detector are achieved when Vb is maintained as positive as possible and Vcm₂ is set as close to ground as possible.

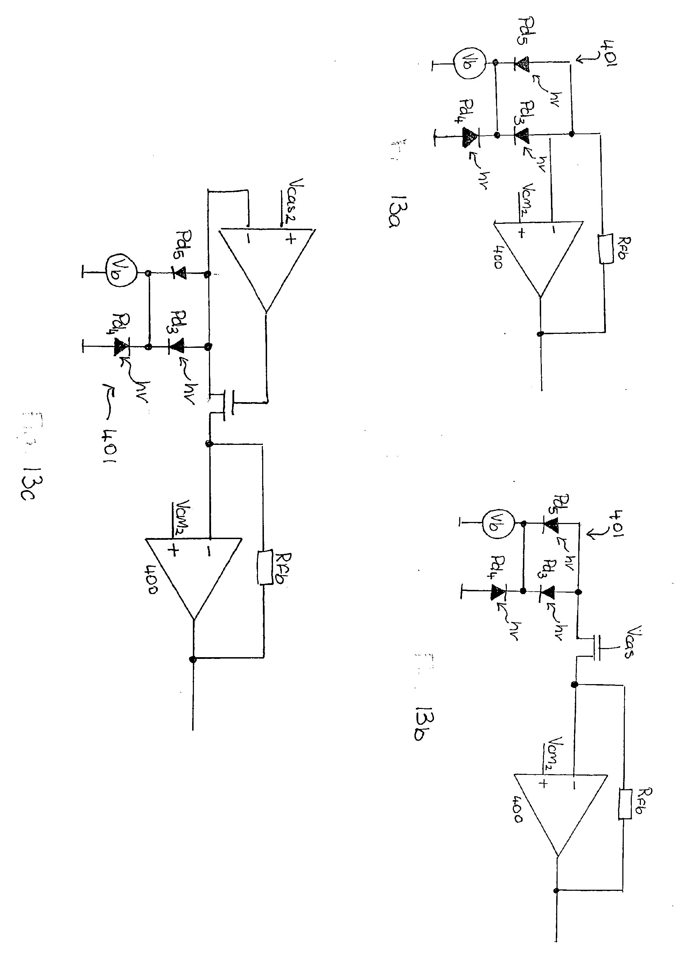

An undesirable side-effect of adding N wells 406 to the photodiode 401 in the fourth photodiode detector (as permitted by the operation of the amplifier 400) is an increase in the capacitance of the photodiode 401. This limits the operating speed of the circuit shown in Figure 13a, as the output of the circuit is limited by the resistance of the feedback resistor (R_{fb}) and the parasitic capacitance of Pd₃ and Pd₅. Since R_{fb} must be large to obtain a large gain from the transimpedance amplifier 400, the resulting RC time constant of the circuit also increases.

There are several known ways of isolating the capacitance of a photodiode from a feedback resistive element. A common technique is to use a "cascode" transistor (as shown in Figure 13b). However, further improvements can be obtained by using a regulated cascode structure (as shown in Figure 13c).

The photodiode 401 in the fourth photodiode detector uses two vertical diodes, with inhibition deep within the bulk semiconductor material. Although the majority of photo- generated charge carriers are produced deep within the bulk semiconductor material, a number of photo-generated charge carriers are nonetheless produced nearer the top surface of the photodiode. These photogenerated charge carriers are also outside the collection depletion zone (452 in Figures 10 and 12) and hence will take a considerable period of time to be detected.

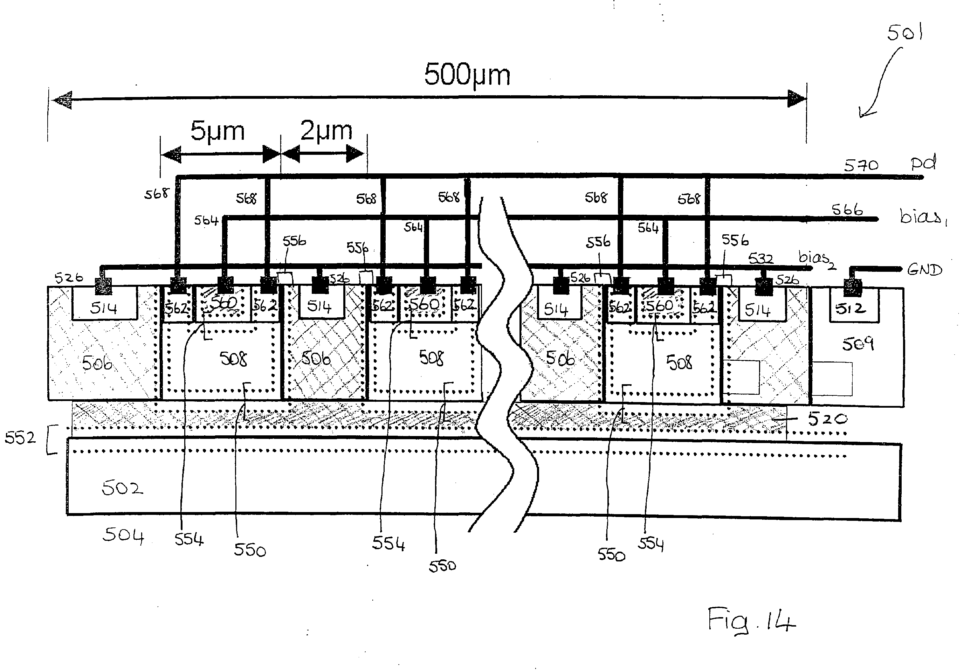

The photodiode in the fifth photodiode detector employs three vertical depletion regions and a horizontal depletion region wherein the top-most depletion region absorbs the charge carriers generated near the top surface of the photodiode and prevents these charge carriers from degrading the overall performance of the photodiode detector. Referring to Figure 14, in common with the previous photodiode detectors the photodiode 501 in the fifth photodiode detector comprises a P substrate 504 implanted with a P epitaxial layer 502. A portion of the P epitaxial layer 502 is coated with a NISO layer 520. The NISO layer 520 is implanted in turn a series of alternating P wells 508 and N well guard rings 506.

Electrical contact between the N well guard rings 506 and the outside world is provided by a highly doped N+ implant 514 in each N well 506. The electrical contact with each N well guard ring 506 is completed by a contact 526 embedded at one end in the N+ implant 514 and connected at the other end to wiring 532. The wiring 532 connects all the N+ implants 514 in parallel.

In contrast with the photodiode in the fourth photodiode detector, electrical contact between each light-collecting P well 508 in the fifth photodiode detector and the outside world is provided by a highly doped N+ implant 560 with a highly doped P+ implant 562 on either side. It will be noted that the P+ implant 562 may also be disposed at the edges or corners of the P well 508. Electrical contact with each N+ implant 560 is completed by a contact 564 embedded at one end in the N+ implant 560 and connected at the other end to conductor 566. Electrical contact with each P+ implant 562 is completed by a contact 568 embedded at one end in each P+ implant 562 and connected at the other end to a conductor 570.

Comparing Figure 14 with Figure 10 it can be seen that the photodiode 501 in the fifth photodiode detector includes three vertical depletion regions 550, 552 and 554 and one horizontal depletion region 556.

The first vertical depletion region 554 exists at the junction between the N+ implant 560 and the P well 508. The second vertical depletion region 550 is formed at the junction between the P wells 508 and the NISO layer 520. The third vertical depletion region 552 is formed at the junction between the NISO layer 520 and the P epitaxial layer 502.

The photodiode 501 in the fifth photodiode detector further comprises the horizontal depletion region 556 formed at the junction between the P well 508 and the N well 506.

In a similar fashion to the photodiode in the fourth photodiode detector, the signal produced by the photodiode 501 in the fifth photodiode detector is obtained by measuring the photo-generated charge collected at second vertical depletion region 550.

For optimal performance, the N+ implants 560 should be as large as possible and the P+ implants 562 should be as small as possible. Optimally the N wells 506 and P wells 508 should be biased so that the first vertical depletion region 554 extends to reach the second vertical depletion region 550. If this is achieved, then there is an electric field over the entire region where photo-generated signal is created and the electric field ensures speedy collection of the photo-charge.

Even if it is not possible to bias the wells to ensure the depletion region covers the whole of the volume of the semiconductor, the first vertical depletion region 554 will nonetheless inhibit photo-charge carriers produced at the top surface of the semiconductor from slowly defusing down to the second vertical depletion region (i.e. collection diode) 550.

In a similar fashion to the photodiode in the fourth photodiode detector, contacts to the P substrate 504 in the photodiode in the fifth photodiode detector are required. If the P substrate 504 is comprised of P+ material or a P epitaxial layer 502, the contact is a P well 509 or a P+ material 512.

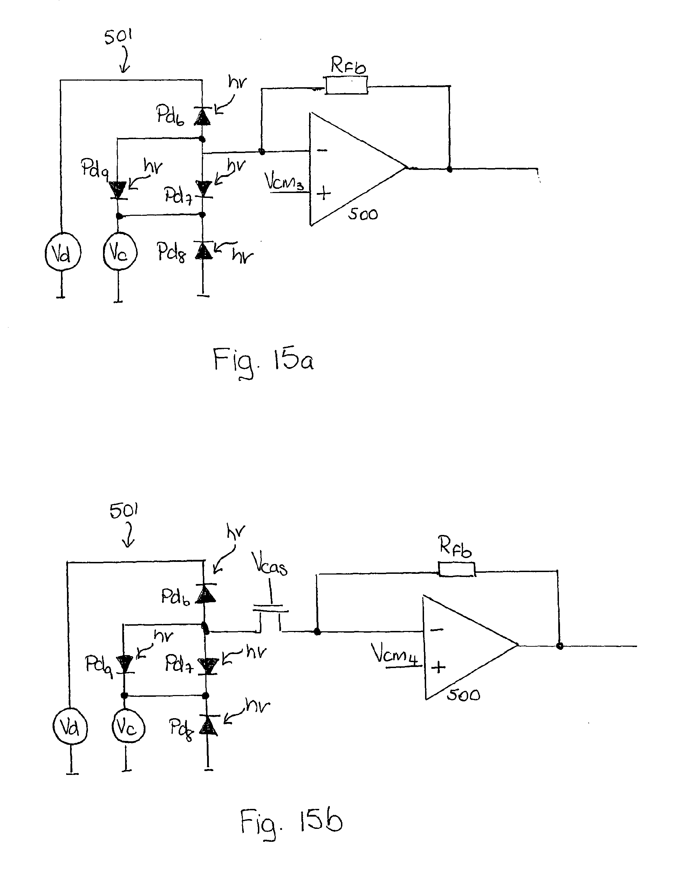

Figure 15a shows a schematic diagram of the fifth photodiode detector with a transimpedance amplifier 500. Comparing Figure 15a with Figure 14 it can be seen that photodiodes Pd₆, Pd₇ and Pd₈ correspond with vertical depletion regions 554, 550 and 552 respectively. Finally, photodiode Pd₉ is equivalent to the horizontal depletion region 556.

In use, voltages Vc and Vd are set positive to ensure that diodes Pd₆ and Pd₈ are maintained in a reverse biased state and thus capable of collecting photo-generated charge. Vcm₃ is also set as close to ground as possible. The configuration of the amplifier 500 ensures that Vcm₃ is applied to its the inverting input. Consequently, voltage (Vc-Vcm₃) is applied across the photodiodes Pd₇ and Pd₉. Thus Pd₇ and Pd₉ are maintained in a reverse-biased state, thereby creating a depletion region.

The operational amplifier configuration shown in Figure 15a is also preferred because the inverting input node of the operational amplifier 500 is maintained at the same potential as the non-inverting node (Vcm₃). Since the voltages at the terminals of the diodes remain at a constant potential, the depletion regions (corresponding with the diodes) also remain constant. This ensures that the electric fields in the photodiode 501 in the fifth photodiode detector are maintained in an optimal condition.

From the perspective of the charge-collecting function of the photodiode 501 in the fifth photodiode detector, the diodes Pd₇ and Pd₉ are of greatest importance, as these diodes are effectively used to produce the overall output signal from the fifth photodiode detector. Accordingly, the depletion regions corresponding with these diodes (550 and 556 respectively) should have the largest area possible to increase the operating speed of the fifth photodiode detector. Since the size of a depletion region is determined by its doping profile and voltage applied thereto, the size of depletion regions 550 and 556 is increased by increasing the voltage across the diodes Pd₇ and Pd₉. Accordingly, the optimal operating conditions for the photodiode 501 in the fifth photodiode detector (as permitted by the operation of the amplifier 500) are achieved when Vc is maintained as positive as possible and Vcm₃ is set as close to ground as possible.

As in the photodiode in the second photodiode detector, the process of setting the voltage Vd in the fifth photodiode detector is a more complex affair. Although Vd could be set to the same voltage as Vc, it would cause the first vertical depletion region 554 (corresponding with photodiode Pd₆) to grow at the expense of the second vertical depletion region 550 and the horizontal depletion region 556 (corresponding with photodiodes Pd₇ and Pd₉).

Accordingly, setting Vc at the same voltage as Vd has a negative effect on the fifth photodiode detector's sensitivity to light. Since the voltage across Pd₆ is (Vd-Vcm3), the optimum setting for Vd is that which causes depletion region 554 to grow until it touches depletion region 550. The operating conditions suitable for achieving this effect can be determined theoretically if the doping profile of the process is known. Otherwise, the required operating conditions can be determined experimentally.

As in the fourth photodiode detector, the addition of N wells to the photodiode 501 in the fifth photodiode detector has the undesirable effect of increasing the capacitance of the photodiode 501.

Since the output of a photodiode is dependent upon the resistance of the feedback resistor (R_{fb}) and the parasitic capacitance of Pd₇ in parallel with Pd₉, the increased capacitance of the photodiode 501 in the fifth photodiode detector leads to an increase in the time constant of the photodiode 501. However, as in the fourth photodiode detector, this problem can be overcome by using a cascode transistor to isolate the capacitance of the photodiodes from the feedback resistor R_{fb}. A circuit diagram of the fifth photodiode detector with a cascoded input is shown in Figure 15b. It will of course be understood that the fifth photodiode detector could also be used with a regulated cascode structure as shown in Figure 13c for the fourth photodiode detector.

It will be understood that whilst the above description has focussed so far on a PMOS implementation of the photodiode detector wherein each of the embodiments have been described in terms of a structure comprising a P substrate, P epitaxial layer and NISO layer, the photodiode detector could also be provided in an NMOS implementation wherein the doping nature of the materials employed in the above structures is inverted. In particular, the man skilled in the art will understand that the NMOS implementation of the photodiode detector will be based on a structure comprising a N substrate, N epitaxial layer and PISO layer.

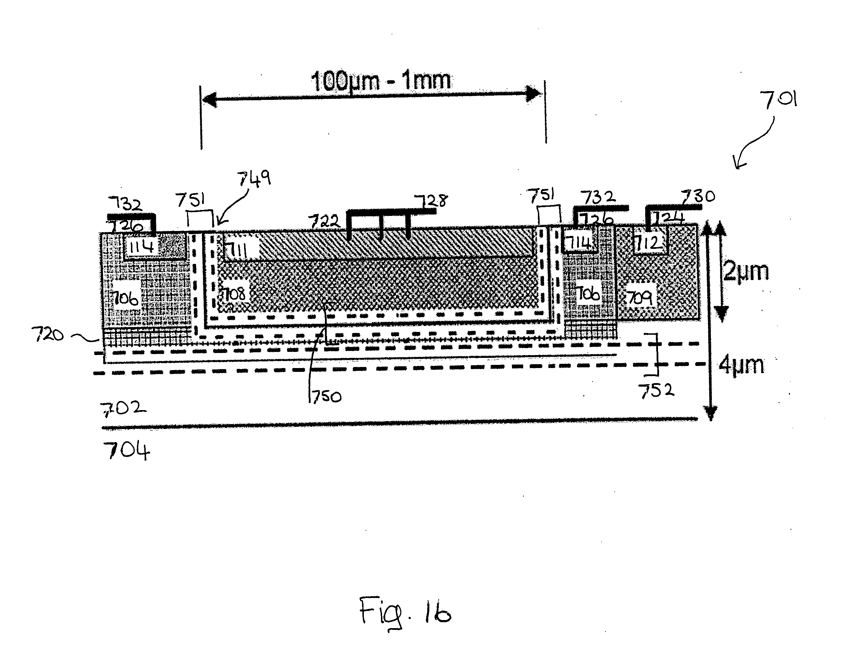

For the sale of clarity, Figure 16 depicts an N-type substrate implementation of the first embodiment of the photodiode detector. The man skilled in the art will understand that the principle of inverting the materials used in the P-type implementation of the first embodiment (shown in Figure 2) in the N-type implementation is also applicable by extension to the other embodiments of the photodiode detector. Referring to Figure 16, the photodiode 701 comprises a N substrate 704 implanted with a N epitaxial layer 702. A PISO layer 720 is implanted into a portion of the N epitaxial layer 702 and a N well 708 and a P well 706 are implanted into the PISO layer 720. A further N well 709 is implanted into the N epitaxial layer 702 in a position adjoining one of the P wells 706.

The PISO layer 720, N well 708 and P wells 706 effectively form a triple well structure in the N epitaxial layer 702. Electrical contact between the N wells 708 and 709 and the outside world is provided by highly doped N+ implants 711 and 712 in the N wells 708 and 709 respectively. The electrical contact is completed by contacts 722 and 724 embedded at one end in the N+ implants 711 and 712 respectively and connected at their other end to conductors 728 and 730 respectively.

Electrical contact between the P wells 706 and the outside world is provided by a highly doped P+ implant 714 in each P well 706. The electrical contact is completed by contacts 726 embedded at one end in each of the P+ implants 714 and connected at the other end to conductors 732. The conductors 728, 730 and 732 may be fabricated from a metal, a polysilicon (with field oxide underneath to prevent the formation of parasitic transistors) or other local-interconnect.

The photodiode 701 includes two depletion regions 749 and 752. The first depletion region 749 comprises a horizontal component 751 and a vertical component 750. The vertical component 750 is located at the junction between the N well 708 and the PISO layer 720. The horizontal component 751 is located at the junction between the P well 706 and the N well 708.

The second depletion region 752 is located at the junction between the PISO layer 720 and the N epitaxial layer 702. In effect, the two depletion regions 749 and 752 act as two diodes in the vertical direction in which the first depletion region 749 collects photo-generated charge carriers from the surface of the photodiode 701 and the second depletion region 752 collects the photo-generated charge carriers produced in the bulk semiconductor material.

By its nature, the above-described photodiode detectors are applicable to a broad range of devices including digital cameras and optical mice. It will be appreciated that the man skilled in the art may employ standard techniques in order to implement the invention in these and other ways.

Modifications and alterations may be made to the above without departing from the scope of the invention.

## Claims

1. A photodiode (101) comprising a substrate (104) comprised of a first semiconductor material and an isolating layer (120) of a second semiconductor material
wherein the second semiconductor material is of opposite doping character to the first semiconductor material, and
wherein the isolating layer (120) of the second semiconductor material is implanted with one or more wells (108,106) of the first and second semiconductor materials
**characterised in that** the substrate (104) is separated from the isolating layer (120) of the second semiconductor material by an epitaxial layer (102) of the first semiconductor material.

2. A photodiode (101, 401) as claimed in Claim 1 wherein each well (106, 406) of the second semiconductor material is provided with an implant (114, 414) of a fourth semiconductor material and each well (108, 408) of the first semiconductor material is provided with an implant (111, 412) of a third semiconductor material.

3. A photodiode (201, 501) as claimed in Claim 1 wherein each well (206, 506) of the second semiconductor material is provided with an implant (214, 514) of the fourth semiconductor material and each well (208, 508) of the first semiconductor material is provided with an implant (260, 560) of the fourth semiconductor material and one or more implants (262, 562) of the third semiconductor material.

4. A photodiode (101) as claimed in Claim 1 or Claim 2 wherein the isolating layer (120) of the second semiconductor material is implanted with a first well (108) of the first semiconductor material and at least one well (106) of the second semiconductor material adjoining the first well (108) of the first semiconductor material.

5. A photodiode (101) as claimed in Claim 4 wherein each well (106) of the second semiconductor material is provided with an implant (114) of the fourth semiconductor material and the first well (108) of the first semiconductor material is provided with an implant (111) of the third semiconductor material.

6. A photodiode (101) as claimed in Claim 4 or Claim 5 wherein two depletion regions (149 and 152) are formed in the photodiode (101) such that:
the first depletion region (149) comprises a horizontal component (151) and a vertical component (150), wherein the horizontal component (151) is formed at each junction between the wells (106) of the second semiconductor material and the first well (108) of the first semiconductor material and the vertical component (150) is formed at the junction between the first well (108) of the first semiconductor material and the isolating layer of the second semiconductor material (120); and
the second depletion region (152) is formed at the junction between the isolating layer (120) of the second semiconductor material and the epitaxial layer (102) of the first semiconductor material.

7. A photodiode (101) as claimed in any one of Claims 4 to 6 wherein the photodiode comprises a means of receiving a positive voltage across the junction between the isolating layer (120) of the second semiconductor material and the epitaxial layer (102) of the first semiconductor material.

8. A photodiode (101) as claimed in any one of Claims 4 to 7 wherein the photodiode comprises a means of receiving a positive voltage across the junction between the isolating layer (120) of the second semiconductor material and the first well (108) of the first semiconductor material.

9. A photodiode (101) as claimed in any one of Claims 4 to 8 wherein a contact is made between the substrate (104) of the first semiconductor material and an electrical ground by a second well (109) of the first semiconductor material implanted in the epitaxial layer (102) of the first semiconductor material, wherein the second well (109) of the first semiconductor material is provided with an implant (112) of the third semiconductor material and an electrical contact (124) thereto.

10. A photodiode (401) as claimed in Claim 1 or Claim 2 wherein the isolating layer (420) of the second semiconductor material is implanted with a plurality of adjoining alternating wells (408, 406) of the first and second semiconductor materials.

11. A photodiode (401) as claimed in Claim 10 wherein each well (408) of the first semiconductor material is provided with an implant (412) of the third semiconductor material and each well (406) of the second semiconductor material is provided with an implant (414) of the fourth semiconductor material.

12. A photodiode (401) as claimed in Claim 10 or Claim 11 wherein the isolating layer (420) of the second semiconductor material around the periphery of the photodiode is implanted with a well (406) of the second semiconductor material.

13. A photodiode (401) as claimed in any one of Claims 10 to 12 wherein three types of depletion regions are formed within the photodiode (401) so that two of the three types of depletion region inhibit vertical diffusion of photogenerated charge carriers and the remaining type of depletion region inhibits horizontal diffusion of photogenerated charge carriers.

14. A photodiode (401) as claimed in Claim 13 wherein:
the first depletion region (450) is formed at the junction between each well (408) of the first semiconductor material and the isolating layer (420) of the second semiconductor material;
the second depletion region (452) is formed at the junction between the isolating layer (420) of the second semiconductor material and the epitaxial layer (402) of the first semiconductor region; and
the third depletion region (456) is formed at the junction between each well (406) of the second semiconductor material and each well (408) of the first semiconductor material.

15. A photodiode (401) as claimed in Claim 13 or Claim 14 wherein a positive bias voltage is applied across
the junctions between the isolating layer (420) of the second semiconductor material and each well (408) of the first semiconductor material;
the junction between the isolating layer (420) of the second semiconductor material and the epitaxial layer (402) of the first semiconductor region; and
the junction between each well (406) of the second semiconductor material and each well (408) of the first semiconductor material.

16. A photodiode as claimed in any of the preceding Claims wherein the first and second semiconductor materials are P type and N type semiconductor materials respectively, and the third and fourth semiconductor materials are P+ and N+ semiconductor materials respectively.

17. A photodiode as claimed in any one Claims 1 to 15 wherein the first and second semiconductor materials are N type and P type semiconductor materials respectively, and the third and fourth semiconductor materials are N+ and P+ semiconductor materials respectively.

18. A photodiode detector including a photodiode (101) comprising a substrate comprised of a first semiconductor material and an isolating layer of a second semiconductor material
wherein the second semiconductor material is of opposite doping character to the first semiconductor material;
wherein the isolating layer of the second semiconductor material is implanted with one or more wells of the first and second semiconductor materials; and
the substrate is separated from the isolating layer of the second semiconductor material by an epitaxial layer of the first semiconductor material.
**characterised in that** the photodiode detector further comprises a transimpedance amplifier (100) to process the photocurrent output from the photodiode (101).

19. A photodiode detector as claimed in any preceding Claims wherein the transimpedance amplifier is connected to a cascode transistor.

20. A photodiode detector as claimed in any of the preceding Claims wherein the transimpedance amplifier is connected to a regulated cascode transistor.

21. An optical mouse comprising a data transmission means, a movement controlling means and a photodiode detector as claimed in any one of the preceding Claims.

22. A digital camera comprising a focussing means, a data processing means and a photodiode detector as claimed in any of the preceding Claims.
